Europäisches Patentamt

European Patent Office

Office européen des brevets

(11) Publication number: **0 177 066 B1**

# EUROPEAN PATENT SPECIFICATION

(45) Date of publication of patent specification: **24.07.91**  (51) Int. Cl.⁵: **H01L 27/10**

(21) Application number: **85112692.0**

(22) Date of filing: **07.10.85**

(54) Semiconductor memory device with information storage vertical trench capacitor and method of manufacturing the same.

(30) Priority: **05.10.84 JP 209159/84**

(43) Date of publication of application:
**09.04.86 Bulletin 86/15**

(45) Publication of the grant of the patent:
**24.07.91 Bulletin 91/30**

(84) Designated Contracting States:
**DE FR GB**

(56) References cited:
**EP-A- 0 164 829**
**US-A- 4 151 607**

**PATENT ABSTRACTS OF JAPAN, vol. 8, no. 272 (E-284)(1709), 13th August 1984 & JP A 59141262**

(73) Proprietor: **NEC CORPORATION**
**7-1, Shiba 5-chome Minato-ku**
**Tokyo 108-01(JP)**

(72) Inventor: **Ishijima, Toshiyuki c/o NEC Corporation**
**33-1, Shiba 5-chome Minato-ku**
**Tokyo(JP)**
Inventor: **Yoshida, Masaaki c/o NEC Corporation**
**33-1, Shiba 5-chome Minato-ku**
**Tokyo(JP)**

(74) Representative: **Glawe, Delfs, Moll & Partner Patentanwälte**
**Postfach 26 01 62 Liebherrstrasse 20**
**W-8000 München 26(DE)**

## Description

### Background of the Invention

#### Field of the Invention

The present invention relates to a semiconductor memory device, and more particularly to a semiconductor memory device of so-called one-transistor type in which each memory cell comprises one information storage capacitor and one switching transistor connected thereto for writing and reading information on the storage capacitor. The present invention also relates to a method of manufacturing such a semiconductor memory device.

### Description of related art

Heretofore, different type semiconductor devices, which can store binary information or data in terms of electric charges, have been developed and are at present used in various memories such as static random access memories (SRAMs), dynamic random access memories (DRAMs), read only memories (ROMs), etc. The reason for this is that a semiconductor memory of high integration density and large storage capacity can be easily obtained because each memory cell can be formed in a very small area. Among these semiconductor memories, a so-called one-transistor type semiconductor memory has been widely used as the DRAMs. In the one transistor type memory, each memory cell consists of one transistor and one capacitor, and therefore, is small in the number of electric components and in the cell area required to store one bit of information. Accordingly, the one-transistor type semiconductor memory is most excellent in possibility of high integration density.

In integrated circuits, on the other hand, there is a ceaseless demand for increase of integration density or electric components per chip. To increase the integration density, it is necessary to reduce the memory cell size. This means the decrease of the area which can be used for the capacitor in the one-transistor type semiconductor memory cells. However, the decrease of the capacitor area result in decrease in the amount of charge which can be stored in the capacitor. This would lead to frequent occurrence of $\alpha$-ray soft error and shortage of sensitivity of an associated sense amplifier.

In order to avoid the above disadvantages, there have been proposed some capacitor structures for the one-transistor type memory cell, which can have a large charge storage capacity even with reduction of the memory cell area. One of the proposed capacitor structures is a so-called "stacked capacitor cell" which has been proposed by Koyanagi, M. et al. "Novel high density, stacked capacitor MOS RAM", 1978 IEDM, pp 348-351 (December 1978).

In this stacked capacitor, the capacitor cell is formed above the switching transistor. Briefly, a first polycrystalline silicon layer is deposited on a insulator coating covering a switching field effect transistor formed in a substrate, and is electrically connected to the source region of the field effect transistor through a vertical contact hole formed in the insulator coating. An intermediate insulative film is deposited on the first silicon layer, and a second polycrystalline silicon layer is deposited on the intermediate insulative film to cooperate with the first silicon layer so as to form a capacitor. In the memory cell having such a capacitor, the amount of charge stored in the memory cell is determined by the capacitance constituted by the first and second polycrystalline layers. To increase the capacitance to as large as possible, the two polycrystalline layers would have to be extended to cover all the area available to each memory cell.

However, as mentioned above, the increase of the integration density leads to decrease of the cell area, and this inclination cannot be avoided even in the case of the stacked capacitor cell. Therefore, although the stacked capacitor cell can have a charge storage capacitance larger than that of the further prior one-transistor type memory cell in the condition of the same memory cell area, it cannot have a sufficient capacitance when the integration density is further increased.

In addition, the contact hole is required to connect between the source of the switching transistor and one electrode of the stacked capacitor cell. However, the vertical contact hole is a large obstacle to fineness of the memory cell, because the vertical contact hole has a horizontal sectional area and needs an insulator horizontally extending around the contact hole for preventing short-circuit with other wirings. Therefore, in the case of the stacked capacitor cell, it is very difficult to increase the integration density beyond a certain limit.

Further, when the stacked capacitor covers the whole of the switching transistor to obtain a possible maximum capacitance, there is required to stack on the surface of the substrate at least three horizontal conductive layers, i.e., a gate electrode of the switching transistors, and the first and second polycrystalline silicon layers of the stacked capacitor. These stacked conductive layers will introduce large steps on the surface of the semiconductor memory chip, which will be a large cause of break of interconnection wiring on the substrate.

Another proposed capacitor structure is a so-called "corrugated capacitor cell" formed at a trench in an active region of a semiconductor substrate, proposed by Sunami, H. et al. "A corrugated capacitor cell (CCC) for megabit dynamic MOS memories", 1982 IEDM, pp. 806-808 (December 1982). In this case, the trench is coated with an insulator film used as the dielectric film of the capacitor. The trench is then refilled with a conductive material, which is used as one electrode of the capacitor. With this construction, if the substrate is applied with a substrate bias voltage, an inversion layer is generated in the substrate along the surface of the trench. This inversion layer constitutes the other electrode of the capacitor.

As seen from the above, in the case of the corrugated capacitor cell, the trench has to be formed in the active region, and therefore, a high integration density cannot be expected. In addition, the active region including the trench must be isolated by any isolation means such as a field oxide. This is also an obstacle to increase of the integration density.

A semiconductor memory device according to the preamble part of claim 1 is disclosed in JP-A-59 141 262 and Patents Abstracts of Japan, Vol. 8, No. 272 (E-284) (1709). In this device the connection between the source electrode of the switching transistor and the charge storage electrode is realized on the top of the trench by an additional connection layer.

From EP-A-0 164 829 which has been cited under article 54 (3) EPC a memory device is disclosed in which the gate electrode overlaps the first charge storage electrode so that the switching transistor is influenced by the charge storage electrode.

It is the object of the present invention to provide a semiconductor memory device of the above type which can have a sufficient charge storage capacitance irrespectively of the increase of the integration density.

Another object of the present invention is to provide a semiconductor memory device of the above type which allows to increase the integration density by reducing the memory cell area, while ensuring a sufficiently information storage capacity.

A further object of the present invention is to provide a semiconductor memory device of the above type in which the storage capacitor is electrically connected to the switching transistor without the intermediary of a contact hole and without forming a further step on the semiconductor chip surface.

A still further object of the present invention is to provide a semiconductor memory device of the above type in which a storage capacitor is formed without two or more conductive horizontal layers which are deposited on the substrate surface and which provide large steps on the semiconductor chip surface.

An even further object of the present invention is to provide a semiconductor memory device of the above type having the storage capacitor of a sufficient capacitance without providing a trench in an active region of the substrate.

Still another object of the present invention is to provide a semiconductor memory device of the above type which can have the storage capacitor of a sufficient capacitance even if an isolation trench is narrowed because of the increase of integration density.

A further object of the present invention is to provide a method of manufacturing the aforementioned semiconductor memory device.

A still further object of the present invention is to provide a semiconductor device including a capacitor which has a sufficient capacitance without restricting the areas of other electric components formed on the same substrate, and irrespectively of the increase of integration density.

These objects are achieved by a semiconductor memory device which includes a substrate of semiconductor material, and a plurality of programmable memory cells formed on the substrate, each memory cell containing at least one switching transistor comprising a gate electrode which is connected to a word line, said switching transistor being formed in the substrate and isolated from adjacent electric components in the substrate by a trench of a given depth formed in the substrate at the side of the switching transistor, the trench having an inner surface coated with an insulator, and one storage capacitor connected to the switching transistor and formed in the trench at the side of the associated switching transistor, wherein said storage capacitor includes a first vertical electrode provided on the insulator coated inner side wall of the trench and being connected to one conductive region of the switching transistor, wherein the gate electrode does not overlap said first vertical electrode, wherein a vertical insulative layer is provided on the first vertical electrode, and a second vertical electrode is provided on the vertical insulative layer, wherein an opening is formed in the insulator coating on the inner side wall of the trench for connecting the first vertical electrode and the one conductive region, wherein the opening is formed on the upper edge of the insulator coating on the trench side wall, and is filled with a portion of the first vertical electrode so that the first vertical electrode is ohmic-contacted to the one conductive region of the switching transistor through a region of the substrate adjacent to the opening.

With the semiconductor memory device mentioned above, the storage capacitor is vertically formed in the isolation trench which can separate and isolate the memory cell from the adjacent electric component such as another memory cell.

Therefore, it can have a sufficient charge storage capacity by deepening the trench, irrespectively of the integration density. Thus, even if the semiconductor memory device is fabricated at higher integration density or to have narrower trenches, the vertical storage capacitor can have a necessary capacitance which can give a sufficiently high degree of $\alpha$-ray soft error immunity and which does not cause the shortage of the sensitivity of an associated sense amplifier.

Furthermore, the first vertical electrode of the storage capacitor is connected to the one conductive region of the switching transistor through the intermediary of the opening formed in the insulator coating on the trench side wall. Accordingly, since no vertical contact hole is required for the above connection, it is possible to reduce the area of each memory cell without restriction caused by the contact hole.

In addition, the isolation trench is maintained at the same potential as that of the substrate, and cooperates with a channel stopper region of high impurity density formed under the bottom of the isolation trench, so as to surely isolate the memory cells. Therefore, there is not required a large active region in which a trench is formed as in the corrugated capacitor cell, nor is it necessary to provide a field oxide for isolation between adjacent memory cells. Accordingly, the semiconductor memory device of the present invention can has an integration density greatly higher than of the case using the corrugated capacitor cell.

Moreover, the flatness of the semiconductor chip surface is greatly improved, because the capacitor electrodes are merged in the isolation trench and because the interconnection between the switching transistor and the storage capacitor is realized through the opening formed in the insulator coating of the trench side wall so that there is not needed to deposit a conductive layer on the substrate for such a interconnection. Accordingly, there will be less possibility of break of wirings, particularly metallic wirings made on the substrate surface.

Thus, the semiconductor memory device in accordance with the present invention can have a large storage capacity at a high integration density.

In the embodiment of the semiconductor memory device in accordance with the present invention, the opening is formed on the upper edge of the insulator coating on the trench side wall, and is filled with a portion of the first vertical electrode so that the first vertical electrode is ohmic-contacted to the one conductive region of the switching transistor through a region of the substrate adjacent to the opening. In addition, the trench is formed to substantially surround the switching transistor, and the storage capacitor is formed in a trench portion adjacent to the above mentioned conductive region of the switching transistor. Preferably, the trench is of a rectangular shape in a plan view and the storage capacitor is formed to extend over a substantial entire wall of one side of the rectangular shaped trench adjacent to the above mentioned conductive region of the switching transistor Furthermore, the above mentioned one side portion of the trench is completely refilled with the first and second vertical electrodes and the vertical insulative layer which constitute the storage capacitor.

In the preferred embodiment of the semiconductor memory device, at least one pair of adjacent memory cells include a pair of switching transistors, which are isolated from each other by the trench formed between the one pair of transistors. In this embodiment, the first vertical electrode is provided on each of opposite insulator coated side walls of the trench and is electrically connected to one conductive region of the adjacent switching transistor through a opening formed in the insulator coating on each inner side wall of the trench. The vertical insulative layer is provided on each of the first vertical electrodes in the same trench, and a common second electrode is provided between the vertical insulative layers. As a result, one pair of vertical storage capacitors are formed in the trench between the one pair of switching transistors and each of the capacitors is associated to an adjacent one of the two transistors.

Specifically, each switching transistor is an insulated-gate field effect transistor, and one of the source and drain regions of the field effect transistor is contacted to the first vertical electrode through the opening formed in the insulator coating on the trench side wall. In addition, the substrate of semiconductor material is of one conduction type, and the first and second vertical electrodes are formed from a semiconductor material of the conduction type opposite to that of the substrate. In a disclosed embodiment, the substrate of semiconductor material is a p-type single-crystalline silicon substrate, and the first and second vertical electrodes are formed of n-type polycrystalline silicon which is doped with material selected from a group consisting of phosphorus and arsenic. Further, the insulator coating on the side wall of the trench is formed of silicon dioxide, and the vertical insulative layer between the first and second vertical electrodes is constituted of a single layer of insulative material such as silicon dioxide or silicon nitride, a double layer of two insulative materials consisting of for example a silicon dioxide layer formed on the first vertical electrode and a silicon nitride layer deposited on the silicon dioxide layer, or a single layer of dielectric material such as tantalum oxide.

According to a second aspect of the present invention, there is provided a method of manufacturing a semiconductor memory device which includes a plurality of programmable memory cells, each of which contains at least one storage capacitor and one switching transistor connected thereto, comprising the steps of: forming in a substrate of semiconductor material a trench having an inner surface coated with an insulator film; forming a opening in the insulator coating in the proximity of the upper edge portion of the trench; depositing a conductive material on the side wall of the trench to form a first vertical electrode; providing a vertical insulative layer on the first vertical electrode; depositing a conductive material on the vertical insulative layer to fill up the remaining trench space and to form a second vertical electrode which cooperates with the first vertical electrode and the vertical insulative layer so as to constitute one vertical capacitor; and forming one switching transistor adjacent to the opening of the insulator coating in such a manner that one conductive region of the switching transistor is electrically and laterally connected to the first vertical electrode through the opening formed in the trench side wall insulator coating.

Preferably, before the switching transistor is formed, the substrate is heated so that a portion of impurities contained in the first vertical electrode is diffused to the substrate through the opening of the insulator coating on the trench inner wall so as to form a contact region in the substrate adjacent to an upper portion of the first vertical electrode, so that the diffused contact region will be continuous to the one conductive region of the switching transistor when it is formed.

In the specific embodiment, the substrate is a single-crystalline silicon substrate, and the trench is formed by the steps of: forming a first silicon dioxide coating, a silicon nitride coating and a second silicon dioxide coating on the upper surface of the substrate in the mentioned order; depositing a resist pattern on the second silicon dioxide coating excluding an area in which a trench is to be formed; etching the second silicon dioxide coating, the silicon nitride coating and the first silicon dioxide coating by using the resist pattern as a mask; also etching the silicon substrate by using the resist pattern and the second silicon dioxide coating as a mask to from a trench in the silicon substrate; removing the second silicon dioxide coating; and thermally oxidizing the inner surface of the trench thus formed by using the silicon nitride coating as oxidation protecting mask, so that the inner surface of the trench is coated with the silicon dioxide.

Further, the opening is formed in the insulator coating on the trench side wall in accordance with the step of: depositing a resist material on the substrate to perfectly refill the silicon dioxide coated trench and to cover the upper surface of the silicon nitride coating; depositing an insulative material on the resist cover; forming on the insulative material layer a resist pattern having an opening in alignment with the trench and not smaller than the trench; etching the insulative material layer by using the resist pattern as a mask so as to form an opening in the insulative material layer corresponding to the opening of the resist pattern; removing the resist pattern and the resist materials by using the insulative material layer as a mask, to perfect remove the resist pattern and at the same time to remove the resist material on and in the trench so that the trench is filled with the resist material to leave the side wall of the trench upper edge portion in the exposed condition and the substrate is covered with the resist coating having the opening corresponding to the trench; and removing the exposed silicon dioxide coating on the trench side wall by using as the mask the remaining resist material in the trench and on the substrate upper surface, so that the substrate is exposed at the side wall of the upper edge portion of the trench.

Thereafter, the first vertical electrode is formed by the steps of: removing the remaining insulative material layer on the substrate and the remaining resist material; depositing on the substrate a polycrystalline silicon of the conduction type opposite to that of the substrate so as to form on the side wall of the trench a polycrystalline silicon layer which has a thickness not greater than one-third of the gap of the trench and which is directly contacted to the exposed substrate through the opening formed in the upper edge of the silicon dioxide coating on the trench wall; and removing the polycrystalline silicon on the upper surface of the substrate and on the bottom of the trench by a reactive sputter etching so that a first vertical polycrystalline silicon layer remains only on each side wall of the trench so as to form the first vertical electrode.

The insulative layer is formed on the first vertical electrode, for example, by thermally oxidizing the surface of the first vertical polycrystalline silicon layer, and then depositing a silicon nitride film on the substrate and the oxidized surface of the first polycrystalline silicon layer.

In addition, the second vertical electrode is formed by depositing on the surface of the substrate a polycrystalline silicon of the conduction type opposite to that of the substrate so as to perfectly fill the remaining space of the trench, and removing the deposited polycrystalline silicon on the substrate so that the polycrystalline silicon remains only in the trench to constitute a second vertical electrode.

Subsequently, there is thermally oxidized an upper oxidized an upper portion of the first and second vertical polycrystalline silicon layers by using the remaining silicon nitride coating on the substrate as oxidation protection mask, so that a silicon dioxide cover of a substantial thickness is formed on the top end of the first and second vertical polycrystalline silicon layers for protection of these vertical silicon layers. In the course of this thermal oxidation, the impurities contained in the first vertical polycrystalline silicon layer are diffused to the substrate through the opening of the insulator coating on the trench inner wall so as to form a contact region in the substrate adjacent to an upper portion of the first vertical polycrystalline silicon, so that the contact region will be continuous to the one conductive region of the switching transistor when the transistor is formed.

In the succeeding switching transistor forming process, the above mentioned one conductive region of the switching transistor is formed to overlap with the diffused contact region in the substrate adjacent to the upper portion of the first vertical polycrystalline silicon.

The above and other objects, features and advantages of the present invention will be apparent from the following description of preferred embodiments of the invention with reference to the accompanying drawings.

Brief Description of the Drawings

Figure 1 is a circuit diagram showing a portion of a memory cell matrix circuit in a semiconductor memory of the one-transistor type;

Figure 2 is a sectional view of a pair of conventional semiconductor memory cells incorporated with stacked capacitor cells;

Figure 3 is a view similar to Figure 2 but showing a conventional semiconductor memory cell incorporated with a corrugated capacitor cell;

Figure 4 is a sectional view of one memory cell in the semiconductor memory device constructed in accordance with the present invention;

Figure 5 is a sectional view taken along the line V-V in figure 4; and

Figures 6A to 6J are sectional views illustrating the method of manufacturing the semiconductor memory device in accordance with the present invention.

Description of the Preferred Embodiments

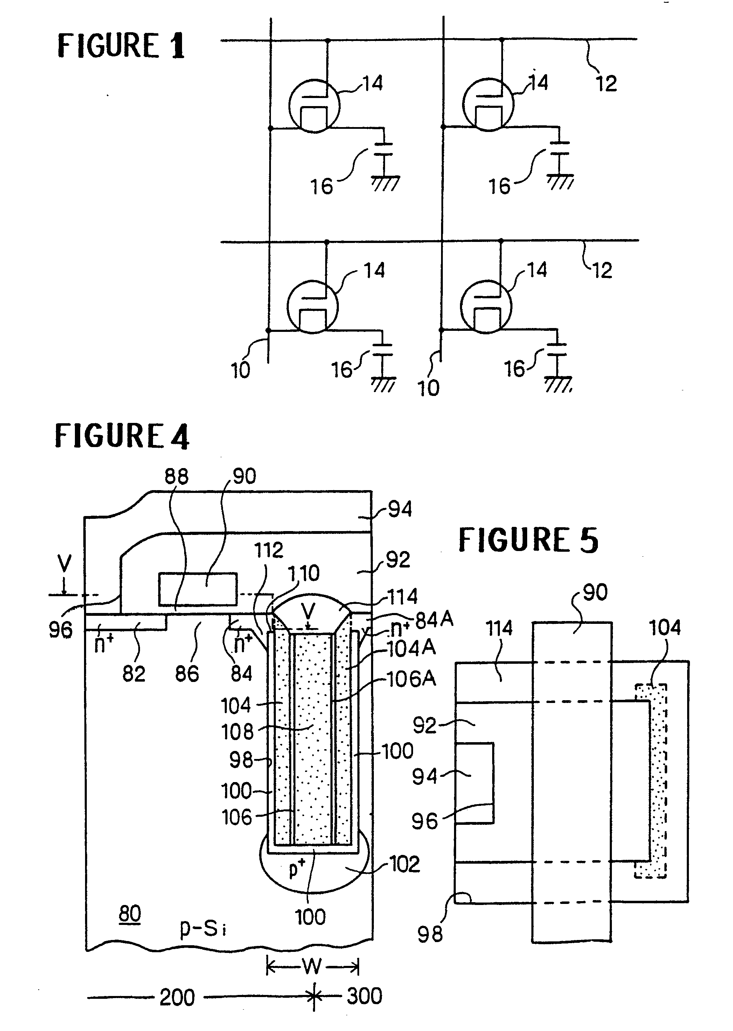

Referring now to Figure 1 of the drawings, there is shown a partial circuit diagram of the memory cell matrix in the one-transistor type semiconductor memory device. The disclosed memory device includes a plurality of column lines or bit lines 10 and a plurality of row lines or word lines 12 intersecting the bit lines 10. At each intersection of the bit lines 10 and the word lines 12, one switching field effect transistor (MOS) 14 is located in such a manner that one terminal of the source-drain path of the MOS transistor 14 is connected to the bit line 10 and the gate is connected to the word line 12. The other terminal of the source-drain path of each switching transistor is connected to one electrode of a storage capacitor 16, whose other electrode is grounded.

With this arrangement, each storage capacitor 16 acts to hold logical information as an electric charge, i.e., a potential, and read-out and write-in of such logical information is effected between the storage capacitor and the bit line 10 through the associated switching MOS transistor 14 by energizing or deenergizing the word line 12 connected to the gate of the same MOS transistor 14. Thus, one memory cell is formed by one switching transistor 14 and one associated capacitor 16.

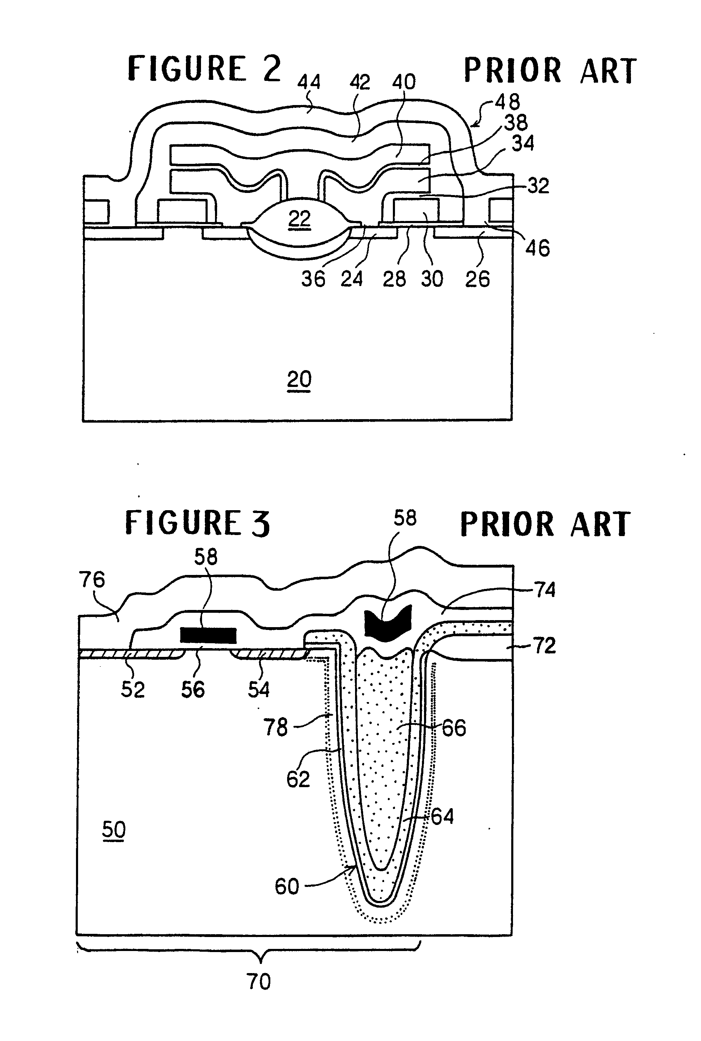

Each memory cell of the above mentioned one-transistor type semiconductor memory is constructed as shown in Figure 2 in the case of using a stacked capacitor cell. In this type of memory cell, a pair of MOS transistor are formed in a silicon substrate 20 and isolated from each other by a selectively oxidized isolation region 22. Each MOS transistor comprises a diffused source and drain regions 24 and 26 formed in the surface portion of the substrate 20 separately from each other. An insulator film 28 is deposited on a substrate region or channel region between the source and drain regions 24 and 26 to overlap those source and drain regions 24 and 26. On the insulator film 28 is deposited a gate electrode 30 in alignment with the channel region between the source and drain regions 24 and 26. This gate electrode 30 serves as a word line.

A lower insulator layer 32 is deposited to cover the gate electrode 30, and a first polycrystalline silicon layer 34 is formed on the lower insulator layer 32 and a portion of the isolation region 22, so as to form one electrode of the capacitor. This first polycrystalline silicon layer 34 is contacted to the source region 24 through a contact hole 36 formed in the insulator film 28 positioning on the source region 24. An intermediate insulator film 38 is coated on the first silicon layer 34 and then a second polycrystalline silicon layer 40 is deposited on the intermediate insulator film 38 so as to form the other electrode of the capacitor which is to be connected to a predetermined potential. Furthermore, an upper insulator layer 42 is deposited to cover the second silicon layer 40 and the MOS transistor, and a conductive layer 44 is deposited on the upper insulator layer 42 to constitute a bit line. This conductive layer 44 is contacted to the drain region 26 through a contact hole 46 formed in the insulator film 28 on the drain region 26.

As seen from the above description with reference to Figure 2, the stacked capacitor cell is formed above the associated MOS transistor. The capacitance of the stacked capacitor cell which determines the information storage capacity in the memory cell, is mainly determined by the area of the capacitor electrodes (34 and 40), namely, the area of the memory cell on which the stacked capacitor cell can be formed. Therefore, if the memory cell area is greatly reduced with a remarkable increase of the integration density, the stacked capacitor cell can no longer have a sufficient capacitance.

The contact hole 36 for interconnecting the source region 24 of the MOS transistor and the one electrode 34 of the stacked capacitor has a horizontal sectional area and needs an insulator film portion 28 and a lower insulator layer portion 32 around the contact hole 36 for preventing the short-circuit with the gate electrode 30 and other wirings. Namely, for the contact hole 36, there has to be retained within each memory cell region a horizontal area larger than the horizontal section of the contact hole. This is a large obstacle to the scale reduction of the memory cell. As mentioned hereinbefore, therefore, if the stacked capacitor is formed in each memory cell, it is very difficult to increase the integration density beyond a certain limit.

Furthermore, the stacked capacitor cell has the gate electrode 30 and the first and second polycrystalline silicon layers 34 and 40 on the upper surface of the substrate 20. These three layers produces a large step 48 at the side of the gate electrode 30 as seen from Figure 2. The bit line wiring 44 extending over the stacked capacitor is apt to be broken at the large step 48.

Turning to Figure 3, there is shown a sectional view of one memory cell associated with the corrugated capacitor cell, which can constitute each one-transistor type memory cell shown in Figure 1. As seen from Figure 3, this memory cell is formed in an active region 70 of a silicon substrate 50 defined by a thick field insulator layer 72. One MOS transistor is formed in the active region 70 to have diffused regions 52 and 54 separately from each other so as to form source and drain regions. An insulator film 56 is formed on the substrate, and a gate electrode and word line wiring 58 is deposited on a channel region between the pair of diffused regions 52 and 54.

At the side of the MOS transistor thus formed, there is formed a trench 60 coated with a insulator film 62. This trench 60 has polycrystalline silicon layers 64 and 66 deposited on the insulator coated wall surface. Thus, a storage capacitor is formed by the silicon layer 64, the insulating film 62 and an inversion layer 78 which is produced to extend along the trench 60 in the substrate 50 of the active region 74 and is connected to the region 54.

Furthermore, an insulative coating 74 is provided to cover the MOS transistor. On the insulator coating 74, a bit line wiring 76 is formed to contact the diffused region 52 through a contact hole. In addition, another word line wiring 58 is formed within the insulative coating 74 above the trench 60.

In the corrugated capacitor having the above mentioned structure, since the trench 60 is formed in the active region 70 of the substrate 50, a large active region is needed, and therefore, it is difficult to increase the integration density. In addition, it is necessary to provide the thick field insulator layer 72 for element isolation. Accordingly, in order to realize a large storage capacity of memory device using the corrugated capacitor cells, a memory chip will inevitably become large.

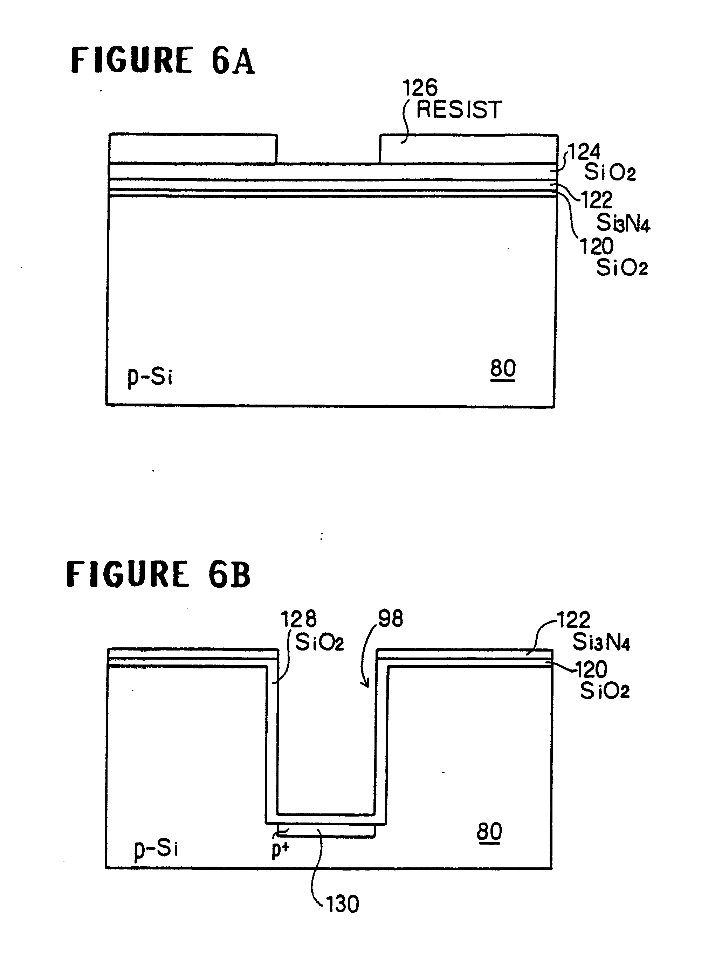

Now referring to Figures 4 and 5, a one-transistor type memory cell, which embodies the present invention, is formed in a substrate 80 of semiconductor material such as a p-type single-crystalline silicon substrate. The memory cell includes one switching MOS transistor composed of a pair of n-type diffused regions 82 and 84 separately from each other to constitute source and drain regions, respectively, and to form a channel region 86 therebetween. An insulator layer 88 such as a silicon dioxide ($SiO_2$) layer is deposited on the diffused regions 82 and 84 and the channel region 86 therebetween, and a gate electrode 90, which also serves as a word line wiring, is formed on the silicon dioxide layer 88 above the channel region 86. Thus, one MOS transistor is formed. Further, a coating 92 of an insulator such as silicon dioxide is deposited to cover the MOS transistor, and a bit line wiring 94 is formed on the insulator coating 92 and is contacted to the diffused region 82, that is, one of source and drain regions, through a contact hole 96, which is formed in a portion of the insulator coating 92 on the diffused region 82.

The switching MOS transistor thus formed is isolated from adjacent MOS transistors (not shown) of other memory cells by a vertical trench 98 of a given depth, which is formed in a rectangular shape in a plan view to surround the MOS transistor as shown in Figure 5 and to vertically downwardly extend into the substrate 80 as shown in Figure 4. This trench 98 has an inner surface coated with an insulator 100 such as silicon dioxide, and a substrate portion 102 under the trench 98 is strongly doped with p-type impurities such as boron to emphasize the p-type in that portion 102. Accordingly, this portion 102 constitutes a channel stopper. In such a trench structure, a first vertical electrode 104, 104A of for example an n-type polycrystalline silicon is formed on the insulator coating 98 of each trench side wall to substantially cover the entire of each side wall as shown in Figures 4 and 5. A insulator film 106, 106A is formed on the first vertical electrode 104, 104A and the remaining trench space is refilled with a conductive material such as an n-type polycrystalline silicon, so that a common second vertical electrode 108 is formed between the pair of first vertical electrode 104.

Further, an opening 110 is formed at each upper edge portion of the trench side wall insulator coating 100 to cause an upper end portion of the first electrode 104, 104A to directly contact with an exposed substrate portion, i.e., the diffused region 84. Specifically, a contact region 112 is formed to continue the diffused region 84, that is, the other of source and drain regions and to contact the first electrode 104 through the opening 110 in the upper end portion of the insulator coating 100. In addition, a cap of insulator such as silicon dioxide is provided on the upper end of the first and second electrodes 104 and 108.

Thus, one vertical storage capacitor is constituted by each first vertical electrode 104 and the common second electrode 108, and one electrode of such a storage capacitor, i.e., the electrode 104 is laterally connected to one conductive region 84 of the MOS transistor. Thus, one memory cell 200 is constituted by one MOS transistor composed of the diffused regions 82 and 84 and the gate 90 and one vertical storage capacitor formed by the vertical electrodes 104 and 108 and the insulator film 106 interposed therebetween. Additionally, another memory cell 300 is constituted by one MOS transistor including the region 84A and another vertical storage capacitor formed in the same isolation trench 98 by the vertical electrodes 104A and 108 and the insulator film 106A therebetween. In this structure, the second electrode 108 is common as one electrode of capacitors respectively incorporated in a large number of memory cells including the left and right memory cells 200 and 300 formed at opposite sides of the trench 98 as shown in Figure 4. Therefore, this common second electrode is connected to a fixed potential such as ground potential.

The vertical capacitor constructed as mentioned above can have a capacitance in proportion to the length and the depth of the trench 98. Therefore, it can a sufficient charge storage capacitance by deepening the trench 98, irrespectively of the integration density. In addition, if the insulator film 106 can have the thickness of 100-150A, the vertical capacitor can be constructed without a fear of short-circuit between the capacitor electrodes 104 and 108, Accordingly, this vertical capacitor can be assembled in a trench having the width W of 1 $\mu$m or less. Thus, even if the semiconductor memory device is fabricated to have narrower trenches to realize higher integration density, the vertical storage capacitor can have a necessary capacitance which can give a sufficiently high degree of $\alpha$-ray soft error immunity and which does not cause the shortage of the sensitivity of an associated sense amplifier. In addition, the left and right memory cells 200 and 300 are isolated from each other with a high reliability by means of a suitable thickness of insulator coating 100 and the strongly doped channel shopper region 102.

Furthermore, the first vertical electrode 104 of the storage capacitor is connected to the diffused region 84 of the MOS transistor through the intermediary of the opening 110 formed in the insulator coating 100 on the trench side wall. Accordingly, since no vertical contact hole is required for the a above connection, it is possible to reduce the area of each memory cell without restriction given by the contact hole.

In addition, since the capacitor electrodes 104 and 108 are merged in the isolation trench 98, it is not necessary to provide the conductive layers 34 and 38 above the switching transistor as shown in Figure 2.

Thus, the semiconductor memory device in accordance with the present invention can have a large storage capacity at a high integration density with less possibility of interconnection wiring on the substrate by substrate surface steps.

A pair of memory cells of the above mentioned structure can be manufactured in the following process.

Namely, there is prepared a p-type single-crystalline silicon substrate 80 as shown in Figure 6A. A first silicon dioxide coating 120, a silicon nitride ($Si_3N_4$) coating 122 and a second silicon dioxide coating 124 are formed on the upper surface of the substrate 80 in the mentioned order, and then, a resist pattern 126 are deposited on the second silicon dioxide coating 124 to coat the surface excluding an area in which a trench is to be formed, as shown in Figure 6A.

In this condition, the second silicon dioxide coating 124, the silicon nitride coating 122 and the first silicon dioxide coating 120 are removed by means of anisotropic etching while using the resist pattern 126 as a mask. Further, the silicon substrate 80 is also etched by anisotropic etching process using the resist pattern 126 and the second silicon dioxide coating 124 as a mask, to form a trench 98 in the silicon substrate, as shown in Figure 6B. Thereafter, the second silicon dioxide coating 124 is removed by etching, and the inner surface of the trench 98 thus formed is thermally oxidized by using the silicon nitride coating 122 as oxidation protecting mask, so that the inner surface of the trench is coated with a silicon dioxide 128. Then, boron ions are implanted to the bottom of the trench 98 by means of ion implantation method using the silicon nitride coating 122 as a mask, so that a p-type emphasized region 130 is formed in a substrate region under the bottom of the trench 98. This condition is shown in Figure 6B.

Subsequently, a resist material 132 is deposited on the substrate to perfectly refill the silicon dioxide coated trench 98 and to cover the upper surface of the silicon nitride coating 122, and then, an insulative layer 134 is formed on the resist layer 132 for example by coating and drying a silicon dioxide dispersed solution.

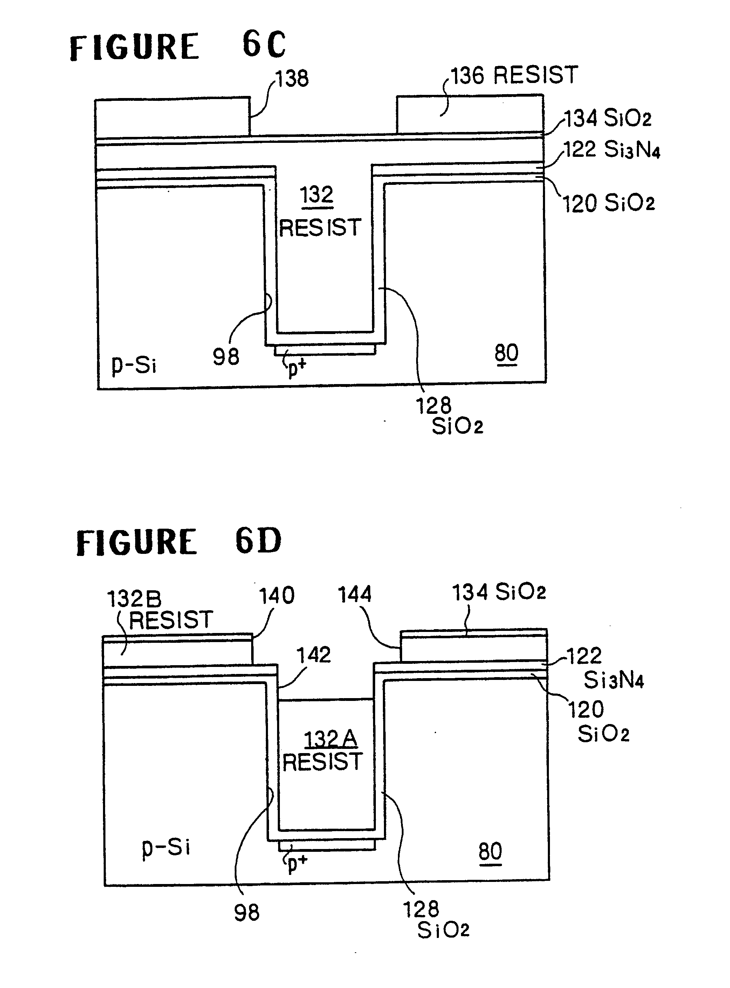

On the insulative material layer 134, there is deposited a resist pattern 136 having an opening 138 in alignment with the trench 98 and slightly larger than the trench, as shown in Figure 6C.

Thereafter, the insulative material layer 134 is etched by using the resist pattern 136 as a mask, so as to form an opening 140 in the insulative material layer 134 corresponding to the opening 138 of the second resist pattern 136. Succeedingly, the resist pattern 136 and the resist materials 132 are etched by using the insulative material layer 134 as a mask, so as to perfect remove the resist pattern 136 and at the same time to remove the resist material 132 on and in the trench 98 so that the remaining resist 132A in the trench has an upper surface lower than the upper surface of the substrate 80. Thus, the trench is filled with the resist material 132A to leave the side wall 142 of the trench upper edge portion in an exposed condition and the substrate 80 is covered with the resist coating 132B having an opening 144 corresponding to but slightly larger than the trench 98, as shown in Figure 6D.

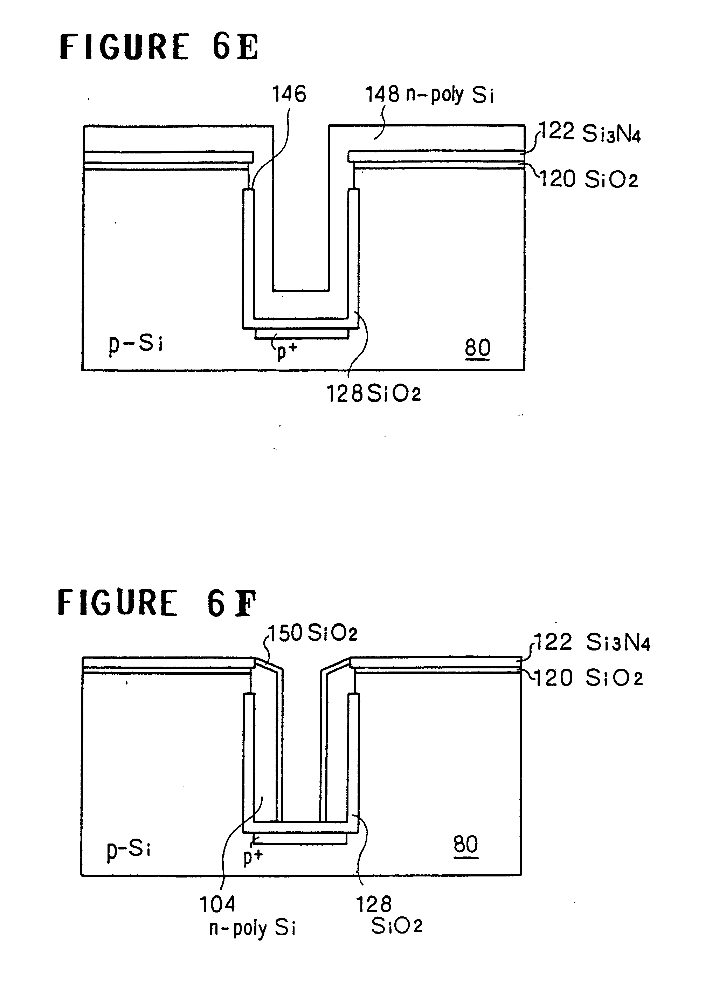

In this condition, the exposed silicon dioxide coating 128 on the trench side wall is etched by using as the mask the resist materials 132A and 132B in the trench 98 and on the substrate upper surface, so that the coating 128 has an opening 146 at the upper edge portion of the trench side wall and the substrate is exposed at the opening 146, as seen from Figure 6E.

Then, there are removed the remaining insulative material layer 132B on the substrate 80 and the remaining resist material 132A in the trench 98. On the whole surface of such a substrate 80, there is deposited a polycrystalline silicon layer 148 of the n-type opposite to the p-type substrate as shown in Figure 6E. This polycrystalline silicon layer 148 has a thickness not greater than one-third of the gap of the trench 98 and is directly contacted to the exposed substrate through the opening 146 formed in the upper edge of the silicon dioxide coating 128 on the trench wall. This n-type polycrystalline silicon layer 148 can be formed by growing a polycrystalline silicon layer on the substrate upper surface and the trench inner surface with chemical vapor deposition (CVD) technique, and then by diffusing n-type impurities such as phosphorus into the grown polycrystalline silicon layer with thermal diffusion method. But, in the thermal diffusion, arsenic or other n-type impurities can be used in place of the phosphorus. Further, the growth of the polycrystalline silicon layer and the succeeding thermal diffusion of n-type impurities can be replaced by a single step of growing a polycrystalline silicon in a condition including the n-type impurities by the CVD technique.

Thereafter, the polycrystalline silicon 148 on the upper surface of the substrate and on the bottom of the trench is removed by a reactive sputter etching, so that a first vertical polycrystalline silicon layer 104 remains only on each side wall of the trench so as to form the first vertical electrode 104. Then, the first vertical polycrystalline silicon layer 104 is thermally oxidized to form a silicon dioxide film 150 thereon, as shown in Figure 6F. Further, a silicon nitride film 152 is deposited on the substrate 80 and the oxidized surface of the first polycrystalline silicon layer 104 by for example the CVD process.

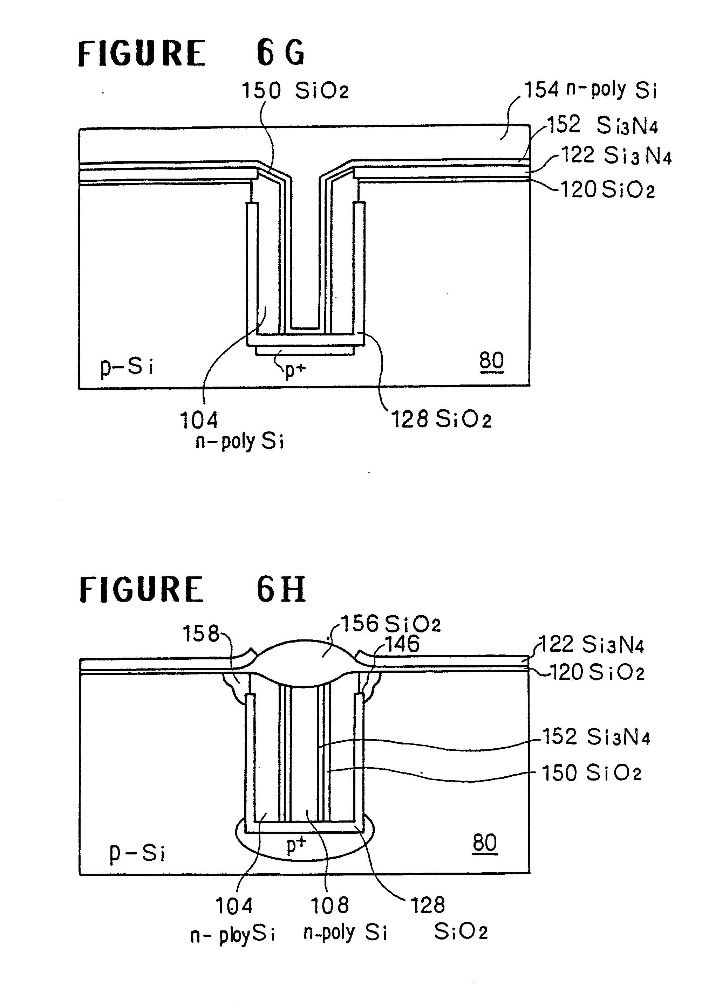

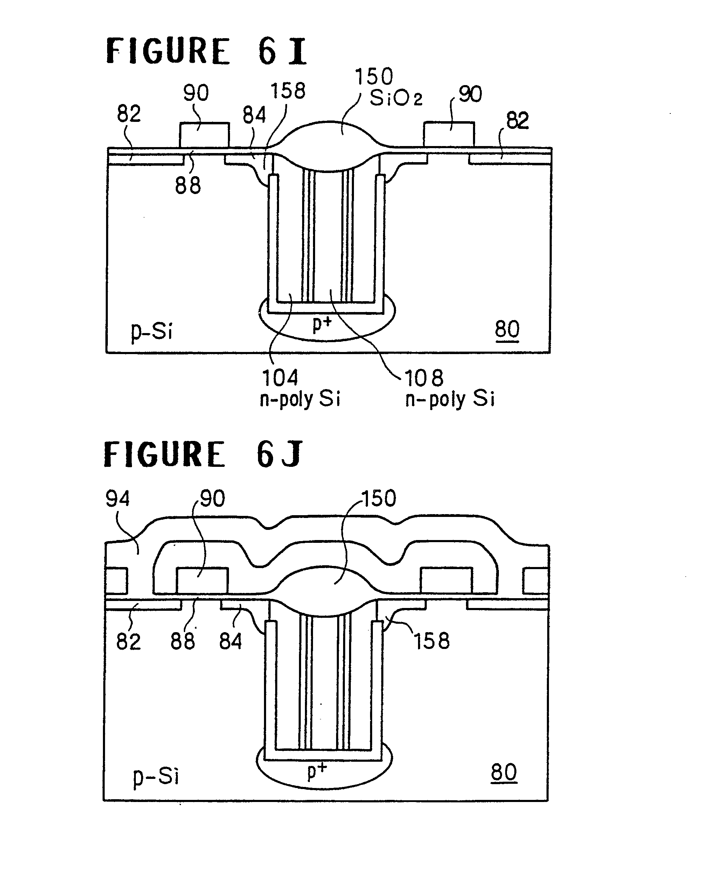

On the whole surface of the substrate thus prepared, there is deposited a polycrystalline silicon 154 of the n-type opposite to the p-type substrate so as to perfectly fill the remaining space of the trench and to coat the upper surface of the substrate, as shown in Figure 6G. For deposition of this polycrystalline silicon 154, various methods used for forming the first electrode 104 can be used. Therefore, the polycrystalline silicon 154 is doped with phosphorus or arsenic or other n-type impurities.

Then, the deposited polycrystalline silicon 154 is removed from the upper surface of the substrate so that the polycrystalline silicon remains only in the trench to constitute a second vertical electrode 108.

Thereafter, there is thermally oxidized an upper portion of the first and second vertical polycrystalline silicon layers 104 and 108 by using the remaining silicon nitride coating 122 on the substrate as oxidation protection mask, so that a silicon dioxide cover 156 of a substantial thickness is formed on the top end of the first and second vertical polycrystalline silicon layers 104 and 108 for protection of these vertical silicon layers, as shown in Figure 6H. At the same time, the impurities contained in the first vertical polycrystalline silicon layer 104 are diffused to the substrate 80 through the opening 146 of the insulator coating 128 on the trench inner wall, so as to form a contact region 158 in the substrate adjacent to an upper portion of the first vertical polycrystalline silicon layer 104. This contact region will be continuous to the one conductive region of the switching transistor when it is formed. In addition, the ion implanted borons under the trench bottom are also diffused in the substrate.

Next. one switching MOS transistor is formed at each side of the trench 98. Namely, as shown in Figure 6I, n-type diffused regions 82 and 84 and the gate insulator film 88 are formed and a gate electrode 90 is deposited in conventional manners. At this time, the diffused region 84 is formed in an overlapped relation to the diffused contact region 158 in the substrate continuous to the upper portion of the vertical polycrystalline silicon layer 104. Thereafter, necessary wirings are made as shown in Figure 6J to complete each memory cell of the one-transistor type.

In the above mentioned manufacturing process, the insulative film 106 is constituted of a double layer of two insulative materials such as a silicon dioxide layer 150 and a silicon nitride layer 152. However, the insulative film 106 can be formed of a single layer of insulative material such as silicon dioxide or silicon nitride, or a single layer of dielectric material such as tantalum oxide.

In accordance with the above mentioned manufacturing process, semiconductor memory devices have been actually fabricated such that each memory cell has an area of 9 $\mu m^2$ and a vertical storage capacitor is formed in a trench portion of the depth 7.2 $\mu m$, the length 2 $\mu m$ and the width 1 $\mu m$, by providing the insulator film 106 of the thickness 100A. As a result, the capacitance of capacitor thus formed was 50 fF.

The invention has thus been shown and described with reference to specific embodiments. However, it should be noted that the invention is in no way limited to the details of the illustrated structures but changes and modifications may be made within the scope of the appended claims.

## Claims

1. A semiconductor memory device which includes a substrate (80) of semiconductor material, and a plurality of programmable memory cells formed on the substrate (80), each memory cell containing at least one switching transistor comprising a gate electrode (90) which is connected to a word line, said switching transistor being formed in the substrate (80) and isolated from adjacent electric components in the substrate by a trench (98) of a given depth formed in the substrate (80) at the side of the switching transistor, the trench (98) having an inner surface coated with an insulator (100), and one storage capacitor connected to the switching transistor and formed in the trench (98) at the side of the associated switching transistor, wherein said storage capacitor includes a first vertical electrode (104) provided on the insulator coated inner side wall of the trench (98) and being connected to one conductive region (84) of the switching transistor, wherein the gate electrode (90) does not overlap said first vertical electrode, wherein a vertical insulative layer (106) is provided on the first vertical electrode, and a second vertical electrode (108) is provided on the vertical insulative layer (106), **characterized** in that an opening (110) is formed in the insulator coating (100) on the inner side wall of the trench (98) for connecting the first vertical electrode (104) and the one conductive region (84), wherein the opening (110) is formed on the upper edge of the insulator coating (100) on the trench side wall, and is filled with a portion (112) of the first vertical electrode (104) so that the first vertical electrode (104) is ohmic-contacted to the one conductive region (84) of the switching transistor through a region of the substrate adjacent to the opening.

2. A semiconductor memory device claimed in claim 1, wherein the trench (98) is formed to substantially surround the switching transistor, and wherein the storage capacitor is formed in a trench portion adjacent to the conductive region (84) of the switching transistor.

3. A semiconductor memory device claimed in claim 2, wherein the trench (98) is of a rectangular shape in a plan view and wherein the storage capacitor is formed to extend over a substantial entire wall of one side of the rectangular shaped trench (98) adjacent to the conductive region (84) of the switching transistor.

4. A semiconductor memory device claimed in claim 3, wherein the above mentioned one side portion of the trench (98) is completely refilled with the first and second vertical electrodes (104,108) and the vertical insulative layer (106) which constitute the storage capacitor.

5. A semiconductor memory device claimed in claim 1, wherein at least one pair of adjacent memory cells include a pair of switching transistors which are isolated from each other by the trench (98) formed between the one pair of transistors, and wherein the first vertical electrode (104) is provided on each of opposite insulator coated side walls of the trench (98) and is electrically connected to one conductive region (84) of the adjacent switching transistor through an opening formed in the insulator coating on each inner side wall of the trench (98), the vertical insulative layer being provided on each of the first vertical electrodes (104) in the same trench, and a common second electrode (108) being provided between the vertical insulative layers (106), whereby one pair of vertical storage capacitors are formed in the trench between the one pair of switching transistors and each of the capacitors is associated to an adjacent one of the two transistors.

6. A semiconductor memory device claimed in claim 5, wherein the opening (110) is formed on the upper edge of the insulator coating on each trench side wall, and is filled with a portion of the first vertical electrode so that each first vertical electrode is ohmic-contacted to the one conductive region of the adjacent switching transistor through a region of the substrate adjacent to the opening.

7. A semiconductor memory device claimed in claim 6, wherein the trench between the one pair of switching transistors is completely refilled with the first and second vertical electrodes (104,108) and the vertical insulative layers (106) which constitute the above mentioned one pair of storage capacitors, and wherein each of the first vertical electrodes has a thickness not greater than one-third of the gap of the trench.

8. A semiconductor memory device claimed in claim 1, wherein each switching transistor is an insulated-gate field effect transistor, one of the source and drain regions of the field effect transistor being contacted to the first vertical electrode (104) through the opening (110) formed in the insulator coating on the side wall of the trench.

9. A semiconductor memory device claimed in claim 1, wherein the substrate of semiconductor material is of one conduction type, and therein the first and second vertical electrodes (104,108) are formed from a semiconductor material of the conduction type opposite to that of the substrate.

10. A semiconductor memory device claimed in claim 1, wherein the substrate of semiconductor material is a p-type single-crystalline silicon substrate, and wherein the first and second vertical electrodes (104,108) are formed of n-type polycrystalline silicon which is doped with material selected from a group consisting of phosphorus and arsenic.

11. A semiconductor memory device claimed in claim 10, wherein the insulator coating on the side wall of the trench is formed of silicon dioxide, and wherein the vertical insulative layer (106) between the first and second vertical electrodes is constituted of a silicon dioxide layer formed on the first vertical electrode (104) and a silicon nitride layer deposited on the silicon dioxide layer.

12. A semiconductor memory device claimed in claim 11, wherein each switching transistor is an insulated-gate field effect transistor, one of the source and drain regions of the field effect transistor being contacted to the first vertical electrode through the opening (110) formed in the insulator coating on the side wall of the trench.

13. A semiconductor memory device claimed in claim 12, further including a plurality of column lines (10) and a plurality of row lines (12) intersecting the column lines and wherein the plurality of memory cells are disposed at the intersections of the column lines (10) and the row lines (12) in such a manner that each switching field effect transistor (14) has a gate connected to the corresponding one of the row lines, and the other of the source and drain regions is connected to the corresponding one of the column (10).

14. A method of manufacturing a semiconductor memory device according to any of the preceding claims which includes a plurality of programmable memory cells, each of which contains at least one storage capacitor and one switching transistor connected thereto, comprising the step of:

Forming in a substrate (80) of semiconductor material a trench (98) having an inner surface coated with an insulator film; forming an opening (110) in the insulator coating in the proximity of the upper edge portion of the trench; depositing a conductive material on the side wall of the trench to form a first vertical electrode (104); providing a vertical insulative layer (150) on the first vertical electrode; depositing a conductive material (154) on the vertical insulative layer to fill up the remaining trench space and to form a second vertical electrode (108) which cooperates with the first vertical electrode (104) and the vertical insulative layer so as to constitute one vertical capacitor; and forming one switching transistor adjacent to the opening (110) of the insulator coating in such a manner that one conductive region (84) of the switching transistor is electrically and laterally connected to the first vertical electrode (104) through the opening (110) formed in the trench side wall insulator coating.

15. A method claimed in claim 14, wherein before the switching transistor is formed, the substrate (80) is heated so that a portion of impurities contained in the first vertical electrode (104) is diffused to the substrate through the opening of the insulator coating on the trench inner wall so as to form a contact region in the substrate adjacent to an upper portion of the first vertical electrode, so that the diffused contact region will be continuous to the one conductive region of the switching when it is formed.

16. A method claimed in claim 14, wherein the step of forming the opening includes:

Filling the trench with a resist material (132A) while leaving the side wall of the upper edge portion of the trench in an exposed condition; forming on the upper surface of the substrate a layer of resist material (132B) having an opening corresponding to and not smaller than the trench so as to leave the upper edge portion of the trench in an exposed condition; and removing the exposed insulator film on the trench side wall by using as the mask the resist material (132A,B) in the trench and on the substrate upper surface, so that the substrate is exposed at the side wall of the upper edge portion of the trench.

17. A method claimed in claim 16, wherein the filling of the resist material (132A,B) of the trench and the formation of the resist material layer leaving the side wall of the trench upper edge portion in the exposed condition are achieved by:

Depositing the resist material on the substrate to perfectly fill the trench and to coat the overall upper surface of the substrate; depositing an insulative material (140) on the resist coating; forming on the insulative material layer a resist pattern having an opening in alignment with the trench and not smaller than the trench; removing the insulative material layer by using the resist pattern as a mask so as to form an opening in the insulative material layer corresponding to the opening of the second resist film; and removing the resist pattern and the resist materials by using the insulative material layer as a mask, so as to perfectly remove the resist pattern and at the same time to remove the resist material on and in the trench is removed with the result that the trench is filled with the resist material (132A) to leave the side wall of the trench upper edge portion in the exposed condition and the substrate is covered with the resist coating having the opening corresponding to the trench opening to leave the trench.

18. A method claimed in claim 17, wherein before the switching transistor is formed, the substrate (80) is heated so that a portion of impurities contained in the first vertical electrode (104) is diffused to the substrate through the opening of the insulator coating on the trench inner wall so as to form a contact region in the substrate adjacent to an upper portion of the first vertical electrode, so that the contact region will be continuous to the one conductive region of the switching transistor when it is formed in the substrate.

19. A method claimed in claim 14, wherein the substrate is a single-crystalline silicon substrate and wherein the step of forming the trench includes:

Forming a first silicon dioxide coating, a silicon nitride coating and a second silicon dioxide coating on the upper surface of the substrate in the mentioned order; depositing a resist pattern on the second silicon dioxide coating excluding an area in which a trench is to be formed; etching the second silicon dioxide coating, the silicon nitride coating and the first silicon dioxide coating by using the resist pattern as a mask; also etching the silicon substrate by using the resist pattern and the second silicon dioxide coating as a mask to form a trench in the silicon substrate; removing the second silicon dioxide coating; and thermally oxidizing the inner surface of the trench thus formed by using the silicon nitride coating as oxidation protecting mask, so that the inner surface of the trench is coated with the silicon dioxide.

20. A method claimed in claim 19, wherein the step of forming the opening in the insulator coating on the trench side wall includes:

Depositing a resist material on the substrate to perfectly fill the silicon dioxide coated trench and to cover the upper surface of the silicon nitride coating;
depositing an insulative material on the resist cover;
forming on the insulative material layer a resist pattern having an opening in alignment with the trench and not smaller than the trench;
removing the insulative material layer by using the resist pattern as a mask so as to form an opening in the insulative material layer corresponding to the opening of the second resist film;
removing the resist pattern and the resist materials by using the insulative material layer as a mask, to perfect remove the resist pattern and at the same time to remove the resist material on and in the trench so that the trench is filled with the resist material to leave the side wall of the trench upper edge portion in the exposed condition and the substrate is covered with the resist coating having the opening corresponding to the trench; and
removing the exposed silicon dioxide coating on the trench side wall by using as the mask the remaining resist material in the trench and on the substrate upper surface, so that the substrate is exposed at the side wall of the upper edge portion of the trench.

21. A method claimed in claim 20, wherein the removal of the resist pattern and the resist material by using the insulative material layer as the mask is achieved by a reactive sputter etching.

22. A method claimed in claim 20, wherein the step of forming the first vertical electrode (104) includes:

Removing the remaining insulative material layer on the substrate (80) and the remaining resist material;
depositing on the substrate a polycrystalline silicon of the conduction type opposite to that of the substrate so as to form on the side wall of the trench a polycrystalline silicon layer which has a thickness not greater than one-third of the gap of the trench and which is directly contacted to the exposed substrate through the opening formed in the upper edge of the silicon dioxide coating on the trench wall; and
removing the polycrystalline silicon on the upper surface of the substrate and on the bottom of the trench by a reactive sputter etching so that a first vertical polycrystalline silicon layer remains only on each side wall of the trench so as to form the first vertical electrode.

23. A method claimed in claim 22, wherein the provision of the insulative layer on the first vertical electrode (104) is realized by thermally oxidizing the surface of the first vertical polycrystalline silicon layer, and then depositing a silicon nitride film on the substrate and the oxidized surface of the first polycrystalline silicon layer.

24. A method claimed in claim 23, wherein the step of forming the second vertical electrode (108) includes:

Depositing on the surface of the substrate (80) a polycrystalline silicon of the conduction type opposite to that of the substrate so as to perfectly fill the remaining space of the trench; and
removing the deposited polycrystalline silicon on the substrate so that the polycrystalline silicon remains only in the trench to constitute a second vertical polycrystalline layer for the second vertical electrode.

25. A method claimed in claim 24, wherein before the switching transistor is formed, there is thermally oxidized an upper portion of the first and second vertical polycrystalline silicon layers by using the remaining silicon nitride coating on the substrate as oxidation protection mask, so that a silicon dioxide cover of a substantial thickness is formed on the top end of the first and second vertical polycrystalline silicon layers for protection of these vertical silicon layers, and at the same time, the impurities contained in the first vertical polycrystalline silicon layer are diffused to the substrate through the opening of the insulator coating on the trench inner wall so as to form a contact region in the substrate (80) adjacent to an upper portion of the first vertical polycrystalline silicon whereby the contact region will be continuous to the one conductive region of the switching transistor when it is formed.

26. A method claimed in claim 25, wherein the step of forming the switching transistor includes a formation of the above mentioned one conductive region of the switching transistor in an overlapped relation to the diffused contact region in the substrate continuous to the upper portion of the vertical polycrystalline silicon.

**Revendications**

1. Dispositif de mémoire à semi-conducteur qui comporte un substrat (80) de matériau semi-conducteur, et une pluralité de cellules-mémoire programmables formées sur le substrat (80), chaque cellule-mémoire contenant au moins un transistor de commutation comprenant une électrode de grille (90) qui est connectée à une ligne de mots, ce transistor de commutation étant formé dans le substrat (80) et isolé de composants électriques adjacents dans le substrat par un évidement (98) de profondeur donnée, formé dans le substrat (80) d'un côté du transistor de commutation, l'évidement (98) ayant une surface intérieure revêtue d'un isolant (100) et un condensateur de stockage connecté au transistor de commutation étant formé dans l'évidement 98 du côté du transistor de commutation associé, dans lequel ledit condensateur de stockage comporte une première électrode verticale (104) disposée sur la paroi latérale intérieure revêtue d'isolant de l'évidement (98), et connectée à une région conductrice (84) du transistor de commutation, dans lequel l'électrode de grille (90) ne chevauche pas ladite première électrode verticale, dans lequel une couche verticale isolante (106) est disposée sur la première électrode verticale, et une seconde électrode verticale (108) est disposée sur la couche verticale isolante (106), **caractérisé** en ce qu'une ouverture 110 est formée dans le revêtement isolant (100) sur la paroi latérale intérieure de l'évidement (98) pour connecter la première électrode verticale (104) la région conductrice (84), l'ouveture (110) étant formée sur le bord supérieur du revêtement isolant (100) sur la paroi latérale de l'évidement, et étant rempli par une partie (112) de la première électrode verticale (104) de façon à ce que la première électrode verticale (104) soit en contact ohmique avec la région conductrice (84) du transistor de commutation par l'intermédiaire d'une région du substrat qui est adjacente à l'ouverture.

2. Dispositif de mémoire à semi-conducteur selon la revendication 1, dans lequel l'évidement (98) est formé de façon à entourer sensiblement le transistor de commutation, et dans lequel le condensateur de stockage est formé dans une partie évidée adjacente à la région conductrice (84) du transistor de commutation.

3. Dispositif de mémoire à semi-conducteur selon la revendication 2, dans lequel l'évidement (98) est de forme rectangulaire dans une vue en plan et dans lequel le condensateur de stockage est formé de façon à se prolonger sur la quasi-totalité de la paroi d'un côté de l'évidement de forme rectangulaire (98) adjacent à la région conductrice (84) du transistor de commutation.

4. Dispositif de mémoire à semi-conducteur selon la revendication 3, dans lequel la partie latérale mentionnée ci-dessus de l'évidement (98) est entièrement remplie par la première et la seconde électrodes verticales (104, 108) et la couche isolante verticale (106) qui constituent le condensateur de stockage.

5. Dispositif de mémoire à semi-conducteur selon la revendication 1, dans lequel au moins une paire de cellules-mémoire adjacentes comprend une paire de transistors de commutation qui sont isolés l'un de l'autre par l'évidement (98) formé entre la paire de transistors, et dans lequel la première électrode verticale (104) est disposée sur chacune des parois latérales opposées revêtues d'isolant de l'évidement (98) et est électriquement connectée à une région conductrice (84) du transistor de commutation adjacent, au travers d'une ouverture formée dans le revêtement isolant sur chaque paroi latérale intérieure de l'évidement (98), la couche isolante verticale étant disposée sur chacune des premières électrodes verticales (104) d'un même évidement, et une seconde électrode commune (108) étant disposée entre les couches isolantes verticales (106), une paire de condensateurs de stockage verticaux étant formée dans l'évidement entre la paire de transistors de commutation, et chacun des condensateurs étant associé à l'un des deux transistors qui lui est adjacent.

6. Dispositif de mémoire à semi-conducteur selon la revendication 5, dans lequel l'ouverture (110) est formée sur le bord supérieur du revêtement isolant, sur chaque paroi latérale de l'évidement, et est rempli par une partie de la première électrode verticale, de façon à ce que chaque première électrode verticale soit en contact ohmique avec la région conductrice du transistor de commutation adjacent, par l'intermédiaire d'une région du substrat qui est adjacente à l'ouverture.

7. Dispositif de mémoire à semi-conducteur selon la revendication 6, dans lequel l'évidement situé entre la paire de transistors de commutation est entièrement rempli par la première et la seconde électrodes verticales (104, 108), et par les couches verticales isolantes (106) qui constituent la paire mentionnée ci-dessus de condensateurs de stockage, et dans lequel chacune des premières électrodes verticales a une épaisseur non supérieure à un tiers de la largeur de l'évidement.

8. Dispositif de mémoire à semi-conducteur selon la revendication 1, dans lequel chaque transistor de commutation est un transistor à effet de champ à grille isolée, l'une des régions de source et de drain du transistor à effet de champ étant en contact avec la première électrode verticale (104) au travers de l'ouverture (110) formée dans le revêtement isolant sur la paroi latérale de l'évidement.

9. Dispositif de mémoire à semi-conducteur selon la revendication 1, dans lequel le substrat de matériau semi-conducteur présente un certain type de conductivité, et dans lequel la première et la seconde électrodes verticales (104,108) sont d'un matériau semi-conducteur du type de conductivité opposé à celui du substrat.

10. Dispositif de mémoire à semi-conducteur selon la revendication 1, dans lequel le substrat de matériau semi-conducteur est un substrat de silicium monocristallin de type de conductivité p, et dans lequel la première et la seconde électrodes verticales (104,108) sont formées de silicium polycristallin de type n dopé par un matériau sélectionné dans le groupe constitué par le phosphore et l'arsenic.

11. Dispositif de mémoire à semi-conducteur selon la revendication 10, dans lequel le revêtement isolant de la paroi latérale de l'évidement est formé de dioxyde de silicium, et dans lequel la couche isolante verticale (106) située entre les première et seconde électrodes verticales est constituée d'une couche de dioxyde de silicium formée sur la première électrode verticale (104) et d'une couche de nitrure de silicium déposée sur la couche de dioxyde de silicium.

12. Dispositif de mémoire à semi-conducteur selon la revendication 11, dans lequel chaque transistor de commutation est un transistor à effet de champ à grille isolée, l'une des régions de source et de drain du transistor à effet de champ étant en contact avec la première électrode verticale au travers de l'ouverture (110) formée dans le revêtement isolant sur la paroi latérale de l'évidement.

13. Dispositif de mémoire à semi-conducteur selon la revendication 12, comportant en outre une pluralité de colonnes (10) et une pluralité de lignes (12) coupant les colonnes et dans lequel la pluralité de cellules-mémoire sont disposées aux intersections des colonnes (10) et des lignes (12) de telle manière que chaque transistor à effet de champ de commutation (14) ait une grille connectée à la ligne correspondante, et que l'autre des régions de source et de drain soit connectée à la colonne (10) correspondante.

14. Procédé de fabrication d'un dispositif de mémoire à semi-conducteur selon l'une quelconque des revendications précédentes, celui-ci comportant une pluralité de cellules-mémoire programmables, chacune d'entre elles contenant au moins un condensateur de stockage et un transistor de commutation connecté à celui-ci, comprenant les étapes de:
   - formation, dans un substrat (80) de matériau semi-conducteur, d'un évidement (98) ayant une surface intérieure revêtue d'un film isolant;
   - formation d'une ouverture (110) dans le revêtement isolant au voisinage de la partie de bord supérieure de l'évidement;
   - dépôt d'un matériau conducteur sur la paroi latérale de l'évidement pour former une première électrode verticale (104);
   - réalisation d'une couche isolante verticale (150) sur la première électrode verticale;
   - dépôt d'un matériau conducteur (154) sur la couche isolante verticale pour remplir l'espace restant dans l'évidement et former une seconde électrode verticale (108) qui coopère avec la première électrode verticale (104) et la couche isolante verticale en constituant un condensateur vertical; et
   - formation d'un transistor de commutation adjacent à l'ouverture (110) du revêtement isolant de telle manière qu'une région conductrice (84) du transistor de commutation soit électriquement et latéralement connectée à la première électrode verticale (104) au travers de l'ouverture (110) formée dans le revêtement isolant de la paroi latérale de l'évidement.

15. Procédé selon la revendication 14, dans lequel, avant que le transistor de commutation ne soit formé, le substrat (80) est chauffé de manière à ce qu'une partie des impuretés présentes dans la première électrode verticale (104) diffuse vers le substrat au travers de l'ouverture du revêtement isolant sur la paroi intérieure de l'évidement, de façon à former une région de contact dans le substrat au voisinage d'une partie supérieure de la première électrode verticale, et à ce que la région de contact diffusée soit continue avec la région conductrice du transistor de commutation lorsque ce dernier est formé.

16. Procédé selon la revendication 14, dans lequel l'étape de formation de l'ouverture comprend:
    - le remplissage de l'évidement avec un matériau de réserve (132A) tout en laissant la paroi latérale de la partie de bord supérieure de l'évidement à l'état exposé;
    - la formation sur la surface supérieure du substrat, d'une couche de matériau de réserve (132B) ayant une ouverture correspondant et de dimension non inférieure à l'évidement, afin de laisser la partie de bord supérieure de l'évidement à l'état exposé; et
    - l'élimination du film isolant exposé sur la paroi latérale de l'évidement en utilisant comme masque, le matériau de réserve (132A,B) dans l'évidement et sur la surface supérieure du substrat, afin que le substrat soit exposé sur la paroi latérale de la partie de bord supérieure de l'évidement.

17. Procédé selon la revendication 16, dans lequel le remplissage de l'évidement par le matériau de réserve (132A,B) et la formation de la couche de matériau de réserve en laissant la paroi latérale de la partie de bord supérieure de l'évidement à l'état exposé, sont réalisés par:
    - dépôt du matériau de réserve sur la substrat pour remplir parfaitement l'évidement et pour revêtir la totalité de la surface supérieure du substrat;
    - dépôt d'un matériau isolant (140) sur le revêtement de réserve;
    - formation, sur la couche de matériau isolant, d'un motif de réserve ayant une ouverture alignée avec l'évidement et de dimension non inférieure à celle de l'évidement;
    - élimination de la couche de matériau isolant en utilisant le motif de réserve comme masque, de façon à former une ouverture dans la couche de matériau isolant, correspondant à l'ouverture du second film de réserve; et
    - élimination du motif de réserve et des matériaux de réserve en utilisant la couche de matériau isolant comme masque, de façon à éliminer parfaitement le motif de réserve et à éliminer simultanément le matériau de réserve sur et dans l'évidement, le résultat étant que l'évidement est rempli de matériau de réserve (132A) en laissant la paroi latérale de la partie de bord supérieure de l'évidement à l'état exposé et que le substrat est recouvert du revêtement de réserve avec une ouverture correspondant à l'ouverture de l'évidement, de façon à laisser l'évidement dégagé.

18. Procédé selon la revendication 17, dans lequel, avant que le transistor de commutation ne soit formé, le substrat (80) est chauffé de manière à ce qu'une partie des impuretés présentes dans la première électrode verticale (104) diffuse vers le substrat au travers de l'ouverture du revêtement isolant sur la paroi intérieure de l'évidement, de façon à former une région de contact dans le substrat au voisinage d'une partie supérieure de la première électrode verticale, et à ce que la région de contact soit continue avec la région conductrice du transistor de commutation, lorsque ce dernier est formé.

19. Procédé selon la revendication 14, dans lequel le substrat est un substrat de silicium monocristallin et dans lequel l'étape de formation de l'évidement comprend:
    - la formation d'un premier revêtement de dioxyde de silicium, d'un revêtement de nitrure de silicium et d'un second revêtement de dioxyde de silicium sur la surface supérieure du substrat, dans cet ordre;
    - le dépôt d'un motif de réserve sur le second revêtement de dioxyde de silicium, à l'exclusion d'une zone dans laquelle un évidement doit être formé;
    - l'attaque du second revêtement de dioxyde de silicium, du revêtement de nitrure de silicium et du premier revêtement de dioxyde de silicium en utilisant le motif de réserve comme masque;
    - l'attaque du substrat de silicium en utilisant le motif de réserve et le second revêtement de dioxyde de silicium comme masque, pour former un évidement dans le substrat de silicium;
    - l'élimination du second revêtement de dioxyde de silicium; et
    - l'oxydation thermique de la surface intérieure de l'évidement ainsi formé en utilisant le revêtement de nitrure de silicium comme masque de protection contre l'oxydation, de façon à ce que la surface intérieure de l'évidement soit revêtue du dioxyde de silicium.

20. Procédé selon la revendication 19, dans lequel l'étape de formation de l'ouverture dans le revêtement isolant sur la paroi latérale de l'évidement comprend:

- le dépôt d'un matériau de réserve sur le substrat de façon à remplir parfaitement l'évidement revêtu de dioxyde de silicium et à recouvrir la surface supérieure du revêtement de nitrure de silicium;
- le dépôt d'un matériau isolant sur la couverture de réserve;
- la formation, sur la couche de matériau isolant, d'un motif de réserve ayant une ouverture alignée avec l'évidement et de dimension non inférieure à celle de l'évidement;
- l'élimination de la couche de matériau isolant en utilisant le motif de réserve comme masque afin de former une ouverture dans la couche de matériau isolant, correspondant à l'ouverture du second film de réserve;
- l'élimination du motif de réserve et des matériaux de réserve en utilisant la couche de matériau isolant comme masque, afin d'éliminer parfaitement le motif de réserve et d'éliminer simultanément le matériau de réserve sur et dans l'évidement pour que l'évidement soit rempli du matériau de réserve en laissant la paroi latérale de la partie de bord supérieure de l'évidement à l'état exposé et pour que le substrat soit recouvert du revêtement de réserve, l'ouverture de ce dernier correspondant à celle de l'évidement; et
- l'élimination du revêtement de dioxyde de silicium exposé sur la paroi latérale de l'évidement en utilisant le matériau de réserve restant sur la surface supérieure de l'évidement comme masque, afin que le substrat soit exposé sur la paroi latérale de la partie de bord supérieure de l'évidement.

21. Procédé selon la revendication 20, dans lequel l'élimination du motif de réserve et de l'agent de réserve en utilisant la couche de matériau isolant comme masque, est effectuée par attaque par pulvérisation réactive.

22. Procédé selon la revendication 20, dans lequel l'étape de formation de la première électrode verticale (104) comprend:
- l'élimination de couche de matériau isolant restant sur le substrat (80) et du matériau de réserve restant;
- le dépôt, sur le substrat, d'un silicium polycristallin d'un type de conductivité opposé à celui du substrat, afin de former sur la paroi latérale de l'évidement une couche de silicium polycristallin ayant une épaisseur non supérieure à un tiers de la largeur de l'évidement et directement en contact avec le substrat exposé au travers de l'ouverture formée dans le bord supérieur du revêtement de dioxyde de silicium sur la paroi de l'évidement; et
- l'élimination du silicium polycristallin de la surface supérieure du substrat et du fond de l'évidement par attaque par pulvérisation réactive, afin qu'une première couche verticale de silicium polycristallin ne reste que sur chaque paroi latérale de l'évidement, et de former la première électrode verticale.

23. Procédé selon la revendication 22, dans lequel la réalisation de la couche isolante sur la première électrode verticale (104) est effectuée par oxydation thermique de la surface de la première couche verticale de silicium plycristallin, puis dépôt d'un film de nitrure de silicium sur le substrat et sur la surface oxydée de la première couche de silicium polycristallin.

24. Procédé selon la revendication 23, dans lequel l'étape de formation de la seconde électrode verticale (108) comprend:
- le dépôt, sur la surface du substrat (80), d'un silicium polycristallin d'un type de conductivité opposé à celui du substrat, afin de remplir parfaitement le volume restant de l'évidement; et
- l'élimination du silicium polycristallin déposé sur le substrat, afin que le silicium polycristallin ne reste que dans l'évidement pour constituer une seconde couche verticale de silicium polycristallin pour la seconde électrode verticale.

25. Procédé selon la revendication 24, dans lequel, avant que le transistor de commutation ne soit formé, une partie supérieure des première et seconde couches verticales de silicium polycristallin est thermiquement oxydée en utilisant le revêtement de nitrure de silicium restant sur le substrat comme masque de protection contre l'oxydation, afin qu'une couverture de dioxyde de silicium d'épaisseur notable soit formée sur l'extrémité supérieure des première et seconde couches verticales de silicium polycristallin pour la protection de ces couches verticales de silicum, et que les impuretés présentes dans la première couche verticale de silicium polycristallin diffusent vers le substrat au travers de l'ouverture du revêtement isolant sur la paroi intérieure de l'évidement, afin de former une région de contact dans le substrat (80) adjacente à une partie supérieure de la première couche verticale de silicium polycristallin, de façon à ce que la région de contact soit continue avec la région conductrice du transistor de commutation, lorsque celui-ci est formé.

26. Procédé selon la revendication 25, dans lequel l'étape de formation du transistor de commutation comprend la formation de ladite région conductrice du transistor de commutation de façon à ce qu'elle chevauche la région diffusée dans le substrat et à ce qu'elle soit continue avec la partie supérieure de la couche verticale de silicium polycristallin.

## Patentansprüche

1. Halbleiterspeicheranordnung mit einem Substrat (80) aus Halbleitermaterial und einer Anzahl programmierbarer Speicherzellen, die auf dem Substrat (80) gebildet sind, wobei jede Speicherzelle wenigstens einen Schalttransistor mit einer Gate-Elektrode (90) aufweist, die mit einer Wortleitung verbunden ist, besagter Schalttransistor im Substrat (80) gebildet ist und von den benachbarten elektrischen Bauteilen im Substrat mittels einer Rille (98) mit gegebener Tiefe, die im Substrat (80) an der Seite des Schalttransistors ausgebildet ist, isoliert ist, wobei die Innenfläche der Rille (98) mit einem Isolator (100) beschichtet ist, und mit dem Schalttransistor ein Speicherkondensator verbunden ist, der in der Rille (98) auf der Seite des zugehörigen Schalttransistors ausgebildet ist, wobei der Speicherkondensator eine erste Vertikalelektrode (104) aufweist, die auf dem Isolator vorgesehen ist, mit welchem die innere Seitenwand der Rille (98) beschichtet ist, und mit einem leitenden Bereich (84) des Schalttransistors verbunden ist, wobei die Gate-Elektrode (90) nicht die ersten Vertikalelektrode überlappt, auf der ersten Vertikalelektrode eine vertikale Isolierschicht (106) aufgebracht ist, und auf der vertikalen Isolierschicht (106) eine zweite Vertikalelektrode (108) aufgebracht ist, dadurch **gekennzeichnet**, daß in der Isolierbeschichtung (100) an der inneren Seitenwand der Rille (98) eine Öffnung (110) ausgebildet ist, um die erste Vertikalelektrode (104) und den einen leitfähigen Bereich (84) zu verbinden, wobei die Öffnung (110) an der oberen Kante der Isolierschicht (100) an der Rillenseitenwand ausgebildet ist, und mit einem Teil (112) der ersten vertikalen Elektrode (104) gefüllt ist, so daß die erste Vertikalelektrode (104) mit dem einen leitfähigen Bereich (84) des Schalttransistors über einen Bereich des Substrats in der Nähe der Öffnung einen ohmschen Kontakt hat.

2. Halbleiterspeicheranordnung nach Anspruch 1, dadurch **gekennzeichnet**, daß die Rille (98) so geformt ist, daß sie im wesentlichen den Schalttransistor umgibt, und daß der Speicherkondensator in einem Rillenabschnitt in der Nähe des leitfähigen Bereiches (84) des Schalttransistors ausgebildet ist.

3. Halbleiterspeicheranordnung nach Anspruch 2, dadurch **gekennzeichnet**, daß die Rille (98) in einer Draufsicht einen rechteckigen Querschnitt aufweist, und daß der Speicherkondensator so ausgebildet ist, daß er sich über eine im wesentlichen ganze Wand einer Seite der rechteckigen Rille (98) in der Nähe des leitenden Bereiches (84) des Schalttransistors erstreckt.

4. Halbleiterspeicheranordnung nach Anspruch 3, dadurch **gekennzeichnet**, daß der vorstehend genannte eine Seitenteil der Rille (98) vollständig mit der ersten und zweiten Vertikalelektrode (104,108) und der vertikalen Isolierschicht (106) ausgefüllt ist, die den Speicherkondensator bilden.

5. Halbleiterspeicheranordnung nach Anspruch 1, dadurch **gekennzeichnet**, daß wenigstens ein Paar benachbarter Speicherzellen ein Paar Schalttransistoren aufweist, die voneinander durch eine Rille (98), die zwischen dem einen Transistorpaar ausgebildet ist, isoliert sind und die erste Vertikalelektrode (104) auf jeder der einander gegenüberliegenden, isolierend beschichteten Seitenwände der Rille (98) vorgesehen ist, und mit dem einen leitfähigen Bereich (84) des benachbarten Schalttransistors über eine Öffnung, die in der Isolierschicht jeder inneren Seitenwand der Rille (98) elektrische verbunden ist, die vertikale isolierende Schicht auf jeder der ersten Vertikalelektroden (104) in derselben Rille ausgebildet ist, und zwischen den vertikalen Isolierschichten (106) eine gemeinsame zweite Elektrode (108) vorgesehen ist, wobei ein paar der vertikalen Speicherkondensatoren zwischen dem einen Paar der Schalttransistoren in der Rille gebildet ist, und jeder der Kondensatoren einem benachbarten der zwei Transistoren zugeordnet ist.

6. Halbleiterspeicheranordnung nach Anspruch 5, dadurch **gekennzeichnet**, daß die Öffnung (110) an der oberen Kante der Isolierbeschichtung an jeder Rillenseitenwand ausgebildet ist, und mit einem Teil der ersten Vertikalelektrode ausgefüllt ist, so daß jede erste Vertikalelektrode mit dem einen leitenden Bereich des Substrats neben der Öffnung einen ohmschen Kontakt hat.

7. Halbleiterspeicheranordnung nach Anspruch 6, dadurch **gekennzeichnet**, daß die Rille zwischen dem einen Paar Schalttransistoren vollständig mit den ersten und zweiten Vertikalelektroden (104,108) und den vertikalen Isolierschichten (106), die das vorstehend erwähnte eine Paar Speicherkondensatoren bilden, ausgefüllt ist, und daß jede der ersten Vertikalelektroden eine Dicke aufweist, die nicht größer als ein Drittel der Rillenbreite ist.

8. Halbleiterspeicheranordnung nach Anspruch 1, dadurch **gekennzeichnet**, daß jeder Schalttransistor ein isolierter Gate- Feldeffekttransistor ist, wobei der Source- oder der Drainbereich des Feldeffekttransistors über die Öffnung (110), welche in der Isolierbeschichtung an der Seitenwand der Rille ausgebildet ist, mit der ersten Vertikalelektrode (104) elektrisch leitend verbunden ist.

9. Halbleiterspeicheranordnung nach Anspruch 1, dadurch **gekennzeichnet**, daß das Substrat aus einem Halbleitermaterial von vom leitenden Typ besteht, und daß die ersten und zweiten Vertikalelektroden (104,108) aus einem Halbleitermaterial vom Leitertyp entgegengesetzt zu dem des Substrats, gebildet sind.

10. Halbleiterspeicheranordnung nach Anspruch 1, dadurch **gekennzeichnet**, daß das Substrat aus Halbleitermaterial ein Substrat aus p-leitendem, ein-kristallinem Silicium ist, und daß die ersten und zweiten Vertikalelektroden (104,108) aus n-leitendem polykristallinem Silicium gebildet sind, das mit einem Material ausgewählt aus der Gruppe bestehend aus Phosphor und Arsen dotiert ist.

11. Halbleiterspeicheranordnung nach Anspruch 10, dadurch **gekennzeichnet**, daß die Isolierbeschichtung auf der Seitenwand der Rille aus Siliciumdioxid gebildet ist, und daß die vertikale Isolierschicht (106) zwischen der ersten und zweiten Vertikalelektrode aus einer Siliciumdioxidschicht, die auf der ersten Vertikalelektrode (104) ausgebildet ist, und einer Siliciumnitridschicht, die auf der Siliciumdioxidschicht ausgebildet ist, besteht.

12. Halbleiterspeicheranordnung nach Anspruch 11, dadurch **gekennzeichnet**, daß jeder Schalttransistor ein isolierter Gate- Feldeffekttransistor ist, wobei der Source- oder Drainbereich des Feldeffekttransistors über die Öffnung (110), die in der isolierenden Beschichtung auf der Seitenwand der Rille ausgebildet ist, mit der ersten Vertikalelektrode elektrisch leitend verbunden ist.

13. Halbleiterspeicheranordnung nach Anspruch 12, dadurch **gekennzeichnet**, daß weiterhin eine Anzahl Spaltenleitungen (10) und eine Anzahl Zeilenleitungen (12), welche die Spaltenleitungen schneiden, vorgesehen sind, und daß die Anzahl der Speicherzellen an den Schnittpunkten der Spaltenleitungen (10) und der Zeilenleitungen (12) so angeordnet sind, daß jeder schaltende Feldeffekttransistor (14) ein Gate aufweist, das mit der entsprechenden Zeilenleitung verbunden ist, und der jeweils andere Source- oder Drainbereich mit der entsprechenden Spalte (10) verbunden ist.

14. Verfahren zum Herstellen einer Halbleiterspeicheranordnung nach jedem der vorstehenden Ansprüche, mit einer Anzahl von programmierbaren Speicherzellen, von denen jede wenigstens einen Speicherkondensator und einen angeschlossenen Schalttransistor aufweist, mit den Arbeitsschritten:

Erzeugen einer Rille (98) in einem Substrat (80) aus Halbleitermaterial, deren Innenfläche mit einem isolierenden Film beschichtet ist;
Erzeugen einer Öffnung (110) in der isolierenden Beschichtung in der Nähe des oberen Kantenabschnittes der Rille;
Abscheiden eines leitfähigen Materials auf der Seitenwand der Rille, um eine erste Vertikalelektrode (104) zu bilden; Ausbilden einer vertikalen Isolierschicht (150) auf der ersten Vertikalelektrode;
Abscheiden eines leitfähigen Materials (154) auf der vertikalen Isolierschicht, um den verbleibenden Rillenraum aufzufüllen, um eine zweite Vertikalelektrode (108) zu bilden, die mit der ersten Vertikalelektrode (104) und der vertikalen Isolierschicht so zusammenwirkt, daß sie einen vertikalen Kondensator bilden; und
Erzeugen eines Schalttransistors in der Nähe der Öffnung (110) in der Isolierbeschichtung dergestalt, daß ein leitender Bereich (84) des Schalttransistors über die Öffnung (110), die in der Isolierbeschichtung der Rillenseitenwand ausgebildet ist, mit der ersten Vertikalelektrode (104) elektrisch und seitlich verbunden ist.

**15.** Verfahren nach Anspruch 14, dadurch **gekennzeichnet**, daß vor dem Erzeugen des Schalttransistors das Substrat (80) erhitzt wird, so daß ein Teil der Verunreinigungen, die in der ersten Vertikalelektrode (104) enthalten sind, über die Öffnung in der Isolierbeschichtung auf der Rilleninnenwand in das Substrat diffundieren, um im Substrat in der Nähe des oberen Teils der ersten Vertikalelektrode einen Kontaktbereich zu bilden, so daß der diffundierte Kontaktbereich eine Fortsetzung des einen leitenden Bereiches des Schalttransistors bei dessen Erzeugung ist.

**16.** Verfahren nach Anspruch 14, dadurch **gekennzeichnet**, daß der Schritt Erzeugen der Öffnung besteht aus:
Füllen der Rille mit einem Widerstandsmaterial (132A), wobei die Seitenwand des oberen Kantenabschnittes der Rille in einem freigesetzten Zustand verbleibt;
Ausbilden einer Schicht aus Widerstandsmaterial (132B) auf der Oberfläche des Substrats mit einer Öffnung entsprechend und nicht kleiner als der Rille, um den oberen Kantenabschnitt der Rille im freigelegten Zustand zu belassen;
und Entfernen des freigelegten Isolierfilms an der Rillenseitenwand unter Verwendung des Widerstandsmaterials (132A,B) in der Rille und auf der Substratoberfläche als Maske, so daß das Substrat an der Seitenwand des oberen Kantenabschnittes der Rille freigelegt wird.

**17.** Verfahren nach Anspruch 16, dadurch **gekennzeichnet**, daß das Füllen der Rille mit Widerstandsmaterial (132A,B) und Ausbilden der Widerstandsmaterialschicht, die die Seitenwand am oberen Kantenabschnitt der Rille im freigelegten Zustand belassen, erzielt wird durch:

Abscheiden des Widerstandsmaterials auf dem Substrat zum perfekten Ausfüllen der Rille und Beschichten der gesamten Oberfläche des Substrats;
Abscheiden eines Isoliermaterials (140) auf der Widerstandsschicht;
Erzeugen eines Widerstandsmusters auf dem Isoliermaterial mit einer Öffnung, die mit der Rille fluchtet und nicht kleiner als die Rille ist;
Entfernen der Isoliermaterialschicht unter Verwendung des Widerstandsmusters als Maske, um eine Öffnung in der Isoliermaterialschicht entsprechend der Öffnung im zweiten Widerstandsfilm zu erzeugen; und
Entfernen des Widerstandsmusters des Widerstandsmaterials unter Verwendung der Isoliermaterialschicht als Maske, um das Widerstandsmuster perfekt zu entfernen und um gleichzeitig das Widerstandsmaterial an und in der Rille zu entfernen, mit dem Ergebnis, daß die Rille mit dem Widerstandsmaterial (132A) gefüllt worden ist, um die Seitenwand des oberen Kantenabschnittes der Rille im freigelegten Zustand zu belassen und das Substrat ist mit der Widerstandsbeschichtung abgedeckt, welche eine Öffung entsprechend der Rillenöffnung aufweist, um die Rille zu belassen.

**18.** Verfahren nach Anspruch 17, dadurch **gekennzeichnet**, daß vor dem Erzeugen des Schalttransistors das Substrat (80) erhitzt wird, so daß ein Teil der Verunreinigungen, die in der ersten Vertikalelektrode (104) enthalten sind, über die Öffnung in der Isolierbeschichtung auf der Rilleninnenwand in das Substrat diffundieren, um einen Kontaktbereich im Substrat in der Nähe eines oberen Teils der ersten Vertikalelektrode zu bilden, so daß der Kontaktbereich eine Fortsetzung bildet zu dem einen Kontaktbereich des Schalttransistors, wenn dieser auf dem Substrat ausgebildet ist.

**19.** Verfahren nach Anspruch 14, dadurch **gekennzeichnet**, daß das Substrat ein kristallines Silicium - Substrat ist, wobei der Arbeitsschritt zum Erzeugen der Rille besteht aus:

Erzeugen einer ersten Siliciumdioxidschicht, einer Siliciumnitridschicht und einer zweiten Siliciumdioxidschicht auf der Oberfläche des Substrats in der genannten Reihenfolge;
Abscheiden eines Widerstandsmusters auf der zweiten Siliciumdioxidschicht mit Ausnahme eines Bereiches, in dem die Rille erzeugt werden soll;
Ätzen der zweiten Siliciumdioxidschicht, der Siliciumnitridschicht und der ersten Siliciumdioxidschicht unter Verwendung des Widerstandsmusters als Maske;
Ätzen des Siliciumsubstrats unter Verwendung des Widerstandsmusters und der zweiten Siliciumdioxidschicht als Maske, um eine Rille im Siliciumsubstrat zu bilden;
Entfernen der zweiten Siliciumdioxidschicht; und
thermischem Oxidieren der inneren Oberfläche der so geformten Rille unter Verwendung der Siliciumnitridschicht als Oxidationsschutzmaske, so daß die innere Oberfläche der Rille mit Siliciumdioxid beschichtet ist.

**20.** Verfahren nach Anspruch 19, dadurch **gekennzeichnet**, daß der Arbeitsschritt Erzeugen der Öffnung in der Isolierbeschichtung an der Rilleninnenwand besteht aus:

Abscheiden eines Widerstandsmaterials auf dem Substrat zum perfekten Ausfüllen der Siliciumdioxid - beschichteten Rille, um die Oberfläche der Siliciumnitridschicht abzudecken;

Abscheiden eines Isoliermaterials auf der Widerstandsabdeckung;

Erzeugen eines Widerstandsmusters auf der Isoliermaterialschicht, mit einer Öffnung, die mit der Rille fluchtet und nicht schmaler als die Rille ist;

Entfernen der Isoliermaterialschicht unter Verwendung des Widerstandsmusters als eine Maske, um eine Öffnung in der Isoliermaterialschicht entsprechend der Öffnung des zweiten Widerstandsfilms zu bilden;

Entfernen des Widerstandsmusters und Widerstandsmaterials unter Verwendung der Isoliermaterialschicht als Maske, um das Widerstandsmuster perfekt zu entfernen und gleichzeitig das Widerstandsmaterial an und in der Rille zu entfernen, so daß die Rille mit dem Widerstandsmaterial gefüllt ist, um den oberen Kantenbereich an der Seitenwand der Rille im freigelegten Zustand zu lassen, und das Substrat mit der Widerstandsschicht abgedeckt ist, die eine Öffnung entsprechend der Rille aufweist; und

Entfernen der freigelegten Siliciumdioxidschicht auf der Rillenseitenwand unter Verwendung des verbleibenden Widerstandsmaterials in der Rille und auf der Substratoberfläche als Maske, so daß das Substrat an der Seitenwand des oberen Kantenbereichs der Rille freigelegt ist.

21. Verfahren nach Anspruch 20, dadurch **gekennzeichnet**, daß das Entfernen des Widerstandsmusters und Widerstandsmaterials unter Verwendung des Isoliermaterials als Maske durch ein reaktives Zerstäubungsätzen erfolgt.

22. Verfahren nach Anspruch 20, dadurch **gekennzeichnet**, daß der Arbeitsschritt Erzeugen der ersten Vertikalelektrode (104) besteht aus:

Entfernen der auf dem Substrat (80) verbliebenen Isoliermaterialschicht und dem verbliebenen Widerstandsmaterial; Abschalten eines polykristallinen Siliciums von einem Leitertyp entgegengesetzt zu dem des Substrats, auf dem Substrat, um auf der Seitenwand der Rille eine polykristalline Siliciumschicht mit einer Dicke zu erzeugen, die nicht größer als ein Drittel der Breite der Rille ist, und die über die Öffnung, welche in der oberen Kante der Siliciumdioxidschicht auf der Rillenwand ausgebildet ist, direkt mit dem freigelegten Substrat kontaktiert ist;

Entfernen des polykristallinen Siliciums von der Oberfläche des Substrats und dem Boden der Rille durch reaktives Zerstäubungsätzen, so daß nur auf jeder Seitenwand der Rille eine erste vertikale polykristalline Siliciumschicht verbleibt, um die erste Vertikalelektrode zu bilden.

23. Verfahren nach Anspruch 22, dadurch **gekennzeichnet**, daß das Aufbringen der Isolierschicht auf der ersten Vertikalelektrode (104) realisiert wird durch thermisches Oxidieren der Oberfläche der ersten vertikalen polykristallinen Siliciumschicht und Aufbringen eines Siliciumnitridfilms auf das Substrat und die oxidierte Oberfläche der ersten polykristallinen Siliciumschicht.

24. Verfahren nach Anspruch 23, dadurch **gekennzeichnet**, daß der Arbeitsschritt Erzeugen der zweiten Vertikalelektrode (108) besteht aus:

Aufbringen von polykristallinem Silicium von einem Leitertyp entgegengesetzt zu dem des Substrats, auf die Oberfläche des Substrats (80), um den verbleibenden Raum der Rille perfekt auszufüllen; und

Entfernen des auf das Substrat aufgebrachten polykristallinen Siliciums, so daß das polykristalline Silicium nur in der Rille bleibt, um eine zweite vertikale polykristalline Schicht für die Vertikalelektrode zu bilden.

25. Verfahren nach Anspruch 24, dadurch **gekennzeichnet**, daß vor dem Erzeugen des Schalttransistors ein oberer Teil der ersten und zweiten vertikalen, polykristallinen Siliciumschichten thermisch oxidiert wird, indem die auf dem Substrat verbliebene Siliciumnitridschicht als Oxidationsschutzmaske verwendet wird, so daß eine Siliciumdioxidabdeckung von beträchtlicher Dicke auf dem oberen Ende der ersten und zweiten vertikalen, polykristallinen Siliciumschichten zum Schutz dieser vertikalen Siliciumschichten gebildet wird, und gleichzeitig die Verunreinigungen, die in der ersten vertikalen, polykristallinen Siliciumschicht enthalten sind, durch die Öffnung der Isolierbeschichtung der Rilleninnenwand in das Substrat diffundiert werden, um einen Kontaktbereich im Substrat (80) in der Nähe eines oberen Teils der ersten vertikalen, polykristallinen Siliciumschicht zu bilden, wobei der Kontaktbereich eine Fortsetzung zu einem leitfähigen Bereich des Schalttransistors ist, wenn dieser gebildet ist.

**26.** Verfahren nach Anspruch 25, dadurch **gekennzeichnet**, daß der Arbeitsschritt Erzeugen des Schalttransistors besteht aus dem Bilden des vorstehend genannten einen leitfähigen Bereiches des Schalttransistors in überlappter Relation zum diffundierten Kontaktbereich im Substrat als Fortsetzung zum oberen Teil des vertikalen, polykristallinen Siliciums.

# FIGURE 1

# FIGURE 4

# FIGURE 5

FIGURE 2   44  42  40   PRIOR ART

FIGURE 3   58   PRIOR ART

# FIGURE 6A

126
RESIST

124
SiO₂

122
Si₃N₄

120
SiO₂

p-Si

80

# FIGURE 6B

128
SiO₂

98

122
Si₃N₄

120
SiO₂

p-Si

p⁺

80

130

## FIGURE 6C

138
136 RESIST
134 SiO2
122 Si3N4
120 SiO2
132 RESIST
98
p-Si
p+
80
128 SiO2

## FIGURE 6D

132B RESIST
140
144
134 SiO2
142
122 Si3N4
120 SiO2
132A RESIST
p-Si
98
p+
80
128 SiO2

# FIGURE 6E

146   148 n-poly Si   122 Si3N4   120 SiO2   p-Si   p+   80   128 SiO2

# FIGURE 6F

150 SiO2   122 Si3N4   120 SiO2   p-Si   p+   80   104 n-poly Si   128 SiO2

## FIGURE  6G

150 SiO₂  
154 n-poly Si  
152 Si₃N₄  
122 Si₃N₄  
120 SiO₂  

p-Si  
p⁺  
80  

104  
n-poly Si  
128 SiO₂  

## FIGURE  6H

158  
156 SiO₂  
146  
122 Si₃N₄  
120 SiO₂  
152 Si₃N₄  
150 SiO₂  

p-Si  
p⁺  
80  

104  
n-ploySi  
108  
n-poly Si  
128  
SiO₂

# FIGURE 6 I

# FIGURE 6 J